# EUROPEAN PATENT APPLICATION

(11) **EP 4 769 487 A1**
(43) Date of publication of application: **01.07.2026**
(21) Application number: 25181464.6
(22) Date of filing: 06.06.2025
(51) Int. Cl.: H01L 21/78, H01L 21/308

(54) **METHOD OF PLASMA DICING**

(30) Priority: 27.12.2024 GB 202419108
(71) Applicant: SPTS Technologies Limited, NP18 2TA (GB)
(72) Inventor: Croot, Alex, Newport, NP18 2TA (GB); Ansell, Oliver, Newport, NP18 2TA (GB); Hopkins, Janet, Newport, NP18 2TA (GB); Mumford, Roland, Newport, NP18 2TA (GB); Kazemi, Samira Binte, Newport, NP18 2TA (GB)
(74) Representative: Wynne-Jones IP Limited

(57) **Abstract**

According to the invention there is provided a method of plasma dicing a workpiece comprising a compound semiconductor substrate, the method comprising:
providing a workpiece comprising a compound semiconductor substrate;
providing a mask structure on the workpiece, the mask structure comprising an upper layer comprising a hard mask material and a lower release layer between the upper layer and the front side of the workpiece, wherein the mask structure defines one or more dicing lanes; and
plasma dicing the workpiece by a process which comprises plasma etching at least partially through the compound semiconductor substrate along the dicing lanes.

## Description

### Field of the Disclosure

This invention relates to a method of plasma dicing a compound semiconductor substrate, and to related apparatus. The invention relates also to an associated workpiece comprising a compound semiconductor substrate.

### Background of the Disclosure

It is widely acknowledged that compound semiconductor substrates, such as silicon carbide, are extremely hard materials. Fabricating compound semiconductor devices from a compound semiconductor substrate therefore presents several challenges. Conventional means for separating a compound semiconductor substrate into individual dies include mechanical abrasion, such as saws or wires that are impregnated with diamond particles, and laser dicing. As compound semiconductor substrates are typically hard and brittle, these conventional separation means can result in crack propagation within the substrate. These cracks can result in yield loss and/or reliability problems. In addition, the hardness of compound semiconductor substrates can result in relatively slow cutting speeds and high consumption of blade or wire when compared to conventional dicing of these substrates.

To maximise the number of dies that are produced from a compound semiconductor substrate, the area and thickness of dies can be reduced. However, in doing so, the problems mentioned above are typically exacerbated, with thinner substrates typically being more fragile and more prone to cracking, and with cracking potentially forming a relatively large part of the dies, thus potentially causing more significant damage to the dies.

To overcome these problems, plasma dicing can be employed. When plasma dicing silicon substrates, a mask is typically applied to the substrate prior to plasma etching, such that substantially only the unmasked areas of the substrate are etched. This provides several advantages including a significant reduction in cracking, as well as providing an efficient way in which to separate a silicon substrate into individual dies, as multiple parts of the substrate can be diced at the same time. However, there are a number of challenges that need to be overcome before plasma dicing can be considered for compound semiconductor substrates. For example, a relatively physical etch process is required to etch through compound semiconductor substrates compared to a silicon substrate, due to the relative hardness of compound semiconductor substrates. Masks that are typically used for silicon substrates would be rapidly consumed if used with a compound semiconductor substrate, due to the relatively aggressive etching process required to cut through the compound semiconductor substrate. In addition, any mask used with a compound semiconductor substrate must support a high etch rate process such that the process is efficient. As a result of these problems, there is currently no commercially viable process for plasma dicing silicon carbide, despite the great deal of interest in its use in semiconductor device manufacture.

On top of this, consideration needs to be given as to the fate of the mask after the compound semiconductor substrate has been plasma diced, in that the mask needs to be an acceptable component of a semiconductor device, or the mask needs to be removeable. Neither of these scenarios is ideal, as having a mask as a permanent part of the semiconductor device can interfere with its operation, and removing the mask can cause damage and add extra levels of complexity in the creation of these devices.

### Statement of Invention

The present invention, in at least some of its embodiments, addresses the above described problems and desires. In particular, the present invention provides a method and associated apparatus which enable plasma dicing of a workpiece comprising a compound semiconductor substrate.

According to a first aspect of the invention there is provided a method of plasma dicing a workpiece comprising a compound semiconductor substrate, the method comprising:
providing a workpiece comprising a compound semiconductor substrate;
providing a mask structure on the workpiece, the mask structure comprising an upper layer comprising a hard mask material and a lower release layer between the upper layer and the front side of the workpiece, wherein the mask structure defines one or more dicing lanes; and
plasma dicing the workpiece by a process which comprises plasma etching at least partially through the compound semiconductor substrate along the dicing lanes.

In this way, singulation of a workpiece comprising a compound semiconductor substrate can be achieved while enabling a high etch rate, enabling an efficient use of mask material, and enabling the mask to be easily removed without causing damage to the workpiece.

The mask structure can be provided on a front side (otherwise known as the device side) of the compound semiconductor substrate or on a back side of the compound semiconductor substrate.

Dicing lanes can be provided on the mask structure using patterning means as known in the art, such as a scanning laser beam, mechanical means (e.g., a blade), photolithography, etch ablation and/or jet ablation.

Dicing lanes provide openings in the mask structure through which the compound semiconductor substrate can be etched.

Any suitable plasma etching process can be used to plasma etch the compound semiconductor substrate. Etching can be performed using an RF plasma etching process. Alternatively, etching can be performed using an inductively coupled plasma (ICP) etching process.

The workpiece can be attached to a carrier structure. The carrier structure can comprise a tape or a carrier wafer. If the carrier structure comprises a tape, the tape can be supported by a frame structure as known in the art. This type of carrier structure (i.e., comprising a tape supported by a frame structure) can be referred to as a tape and frame carrier structure.

The mask structure can be provided by: applying the release layer to the workpiece; applying the hard mask material to the release layer; and generating dicing lanes in the release layer and the hard mask material.

The mask structure can be provided by: applying the hard mask material to the release layer; applying the release layer to the workpiece; and generating dicing lanes in the release layer and the hard mask material.

The release layer can comprise a material integrable into existing fabrication process flows for deposition on, and/or removal from, the workpiece, such as a material as described herein.

The release layer can comprise a release coating. The release layer can be referred to as an adhesion layer.

The release layer can comprise a water-washable coating. The water-washable coating can comprise carbon-based polymers. The water-washable coating can be a commercially available product as known in the art (e.g., HogoMax^{™} manufactured by Disco or DaeCoat^{™} manufactured by Daetec). The water-washable coating can be provided on the workpiece and/or the mask structure by spin coating.

The release layer can comprise an adhesive tape. The tape can be applied using a tape providing apparatus. The tape can be laminated at an elevated temperature and, optionally under a reduced pressure.

The release layer can comprise polycrystalline silicon, silicon dioxide or germanium oxide. A polycrystalline silicon release layer can be provided on the workpiece and/or the mask structure by chemical vapour deposition (CVD). A silicon dioxide release layer can be provided on the workpiece and/or the mask structure by CVD. A germanium oxide release layer can be provided on the workpiece and/or the mask structure by molecular vapour deposition. A polycrystalline silicon release layer or a silicon dioxide release layer can be removed by a release-etch process. A germanium oxide release layer can be removed by a water based process.

The release layer can comprise a thickness in the range 1-10µm (e.g., 1µm, 3µm, 5µm, 10µm, or the like).

The hard mask material can comprise a metal or a metal alloy. The metal or metal alloy can comprise one or more of copper, nickel, aluminium, indium and tin.

The hard mask material can comprise aluminium oxide (Al₂O₃) and/or indium tin oxide.

The hard mask can be provided on the release layer by known means such as by physical vapour deposition (PVD) or by a technique requiring deposition of a thin seed layer followed by deposition of a thicker layer by ECD (Electrochemical Deposition). The seed layer can be deposited by PVD, or by electroless means.

Alternatively, the hard mask can be provided on the release layer by supporting a metal (e.g., a metal film) using a film (e.g., an organic film) and adhering the metal to the release layer. This avoids the need for a high vacuum system.

The mask structure can comprise a second release layer provided on the hard mask material. The second release layer can be provided on the opposite side of the hard mask material to the side of the hard mask material in which the first release layer is provided. The second release layer can have a thickness of between 1-10µm. In this way, any ablated material resulting from providing dicing lanes in the mask structure that condenses on any surfaces close to the dicing lanes, such as the surface of the hard mask material, can be removed easily (for example by washing with de-ionised water). Allowing removal of the ablated material is advantageous because, if it is not removed, it can result in a degraded etch profile.

The compound semiconductor substrate to hard mask material etch selectivity can be at least 10:1.

The plasma etching of the compound semiconductor substrate can comprise fluorine or chlorine based plasma etching.

The plasma etching of the compound semiconductor substrate can comprise using an etchant gas mixture comprising sulphur hexafluoride and, optionally, oxygen. The etchant gas mixture can additionally comprise an inert gas, such as argon.

The method can comprise the further step of, after plasma etching the compound semiconductor substrate, removing the release layer and the hard mask material.

The release layer and the hard mask material can be removed using an aqueous solution or a release etch process.

The method can comprise the further step of, after plasma etching the compound semiconductor substrate and prior to removing the release layer and the hard mask material, performing a clean step to remove any residue within the dicing lanes (e.g., such as that caused by the interaction of plasma with the release layer). The clean step can comprise a nitric acid etch process.

The workpiece can comprise the compound semiconductor substrate and one or more additional structures formed on the compound semiconductor substrate. The release layer can be in contact with the compound semiconductor substrate and/ or at least some of the additional structures.

The one or more additional structures can comprise a metal layer. Alternatively, or in addition, the one or more additional structures can comprise one or more of silicon dioxide, a polyimide and the like. Alternatively, or in addition, the one or more additional structures can comprise device structures. The device structures can comprise a metal (e.g., a metal layer) and/or an isolation component (e.g., an isolation layer). The one or more additional structures can be provided on the compound semiconductor substrate.

The release layer can comprise a plurality of release coatings.

The compound semiconductor substrate can be a silicon carbide substrate. The Applicant has demonstrated significant improvements to die strength in plasma diced SiC. Alternatively, the compound semiconductor substrate can be a gallium nitride substrate.

The compound semiconductor substrate can be fully etched along the dicing lanes by the plasma etching to achieve singulation of the workpiece.

The thickness of the compound semiconductor substrate can be reduced prior to fully etching the compound semiconductor substrate along the dicing lanes by plasma etching to achieve singulation of the workpiece. This process is commonly referred to as a dicing after grind process. The thickness of the compound semiconductor substrate can be reduced using known processes in the art, such as grinding the substrate.

The compound semiconductor substrate can be partially etched along the dicing lanes by the plasma etching, and subsequently the thickness of the compound semiconductor substrate can be reduced to achieve singulation of the workpiece. This process is commonly referred to as a dicing before grind process. The thickness of the compound semiconductor substrate can be reduced using known processes in the art, such as grinding the substrate.

According to a second aspect of the invention there is provided a system for plasma dicing a workpiece comprising a compound semiconductor substrate, the system comprising:
a mask providing arrangement configured to provide a mask structure on a workpiece comprising a compound semiconductor substrate, the mask structure comprising an upper layer comprising a hard mask material and a lower release layer between the upper layer and the workpiece, wherein the mask structure defines one or more dicing lanes; and
a plasma etching apparatus configured to plasma etch at least partially through the compound semiconductor substrate along the dicing lanes and, optionally, a material removal apparatus configured to reduce the thickness of the compound semiconductor substrate to achieve singulation of the workpiece.

The mask providing arrangement can comprise a PVD apparatus.

The mask providing arrangement can comprise a tape providing apparatus.

The plasma etching apparatus can include a RF plasma etching apparatus or an inductively coupled plasma etching apparatus. The plasma etching apparatus can include etching apparatuses as known in the art. The plasma etching apparatus can comprise a chamber, a plasma production device configured to produce a plasma within the chamber suitable for etching the compound semiconductor substrate, a workpiece support located in the chamber for supporting the workpiece, a gas supply and pumping arrangement for providing etchant gases to the chamber, and a control apparatus configured to control the plasma etching apparatus, including the gas supply and pumping arrangement.

According to a third aspect of the invention there is provided a workpiece comprising a compound semiconductor substrate, the workpiece having a mask structure provided thereon, the mask structure comprising an upper layer comprising a hard mask material and a lower release layer between the upper layer and the workpiece, wherein the mask structure defines one or more dicing lanes.

For the avoidance of doubt, whenever reference is made herein to 'comprising' or 'including' and like terms, the invention is also understood to include more limiting terms such as 'consisting' and 'consisting essentially' where the context allows it.

Whilst the invention has been described above, it extends to any inventive combination of the features set out above, or in the following description, drawings or claims. For example, any features disclosed in relation to the first aspect of the invention may be combined with any features disclosed in relation to the second aspect of the invention and vice versa as appropriate.

### Description of the Drawings

Figure 1 shows (a) a silicon carbide substrate with a backside metal layer, (b) the formation of a release layer, (c) the formation of a mask, (d) generation of dicing lanes, (e) a plasma etching/dicing step, and (f) removal of the mask and the release layer.

Figure 2 shows an image, generated using a scanning electron microscope, of a substrate having a backside metallisation layer (BSM), a water-washable coating, a copper mask and a second water-washable coating.

### Detailed Description of the Disclosure

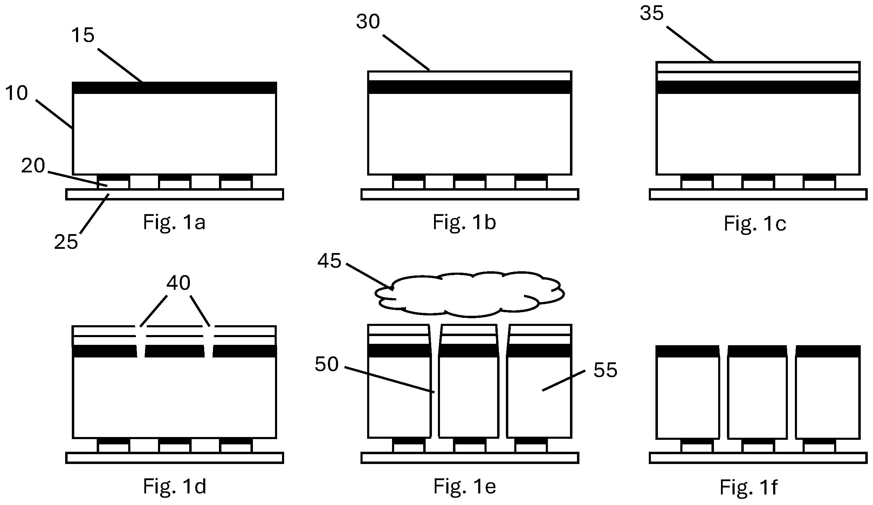

Figure 1 shows an example representation of a process for plasma dicing a workpiece comprising a compound semiconductor substrate, the compound semiconductor substrate comprising a silicon carbide substrate. Fig. 1a shows a workpiece comprising a silicon carbide substrate 10 having a metal layer 15 provided thereon. The silicon carbide substrate 10 with devices structures having frontside metal and isolation is supported by isolation components 20, where the isolation components 20 are attached to a carrier structure 25. The carrier structure comprises a carrier wafer, though a skilled person would recognise that other carrier structures could be used, such as a tape supported by a frame structure (e.g., a tape and frame carrier structure) as known in the art.

Fig. 1b shows the same workpiece as shown in Fig. 1a, where a release layer 30 is provided on the workpiece, in this case on the metal layer 15. The release layer 30 comprises a material integrable into existing fabrication process flows for both deposition onto, and removal from, the workpiece such as a water-washable coating (WWC). A WWC can comprise an organic film formed from carbon-based polymers that are spin-coated onto the workpiece. The release layer 30 has a thickness in the range 1-10 micrometres. An advantage with WWCs is that the release layer 30 can be optimised for use with UV lasers, such as excimer lasers, which are commonly used for laser scribing of the dicing lanes. Once the release layer 30 is provided on the workpiece, the release layer is baked at 200°C to remove any residual water solvent and to ensure stability of the release layer at elevated temperatures (e.g., 200°C). A standard scratch/scribe and tape test as known in the art indicated good adhesion of the WWC to the workpiece. A skilled person would recognise that the release layer 30 can be made from other materials, and deposited onto, and removed from, the workpiece using various processes, as described herein.

Fig. 1c shows the same workpiece as shown in Fig. 1b, where a mask 35 (described below) is provided on the release layer 30. Prior to applying the mask, a 200°C degas step was performed under vacuum to prevent water evolution during deposition which could potentially degrade the release layer 30 or adversely affect adhesion of the mask 35 to the release layer. After performing the 200°C degas step, an 8µm copper mask 35 was applied to the cured WWC coating using physical vapour deposition (PVD) using a commercially available apparatus, namely an SPTS Sigma *fx*P^{™} system produced by SPTS Technologies Limited (Newport, NP18 2TA, UK). A second scratch/scribe and tape test as known in the art indicated good adhesion of the copper mask 35 to the release layer 30 with no delamination being observed. The mask material provides a silicon carbide to mask selectivity of at least 10:1 to enable plasma dicing of a wide range of silicon carbide thicknesses. A skilled person would recognise that the mask 35 can be made from other suitably hard materials as known in the art that are capable of providing a high enough etch selectivity value over the silicon carbide substrate 10, and that the mask can be added to the release layer 30 using other techniques known in the art.

Fig. 1d shows the same workpiece as shown in Fig. 1c, where dicing lanes have been generated in each of the mask 35, the release layer 30 and the metal layer 15. The dicing lanes were generated using laser scribing using an ultraviolet picosecond excimer laser system projecting a beam directly onto the copper mask 35. A skilled person would recognise that dicing lanes can be generated using other known patterning means, such as using photolithography, etch ablation, jet ablation or a blade.

Fig. 1e shows the same workpiece as shown in Fig. 1d, where a plasma 50 has been generated adjacent to the silicon carbide substrate 10. The plasma 45 is used to plasma dice the silicon carbide substrate 10 by etching the silicon carbide substrate 10 through the openings in the mask 35 (i.e., along the dicing lanes) until all of the silicon carbide substrate is removed along a vertical path 50 passing through the silicon carbide substrate thereby achieving singulation of the workpiece. In other words, individual dies 55 are produced. The plasma dicing step is carried out using any suitable etching process. For example, an SF₆ RF plasma can be used (Y. Sano et al. Materials Science Forum Submitted: 2023-09-08 ISSN: 1662-9752, Vol. 1124, pp 51-55, the entire contents of which are herein incorporated by reference). Alternatively, plasma dicing can be carried out using ICP etching with SF₆, oxygen and, optionally, an inert gas (see, for example, US11037793 B2, the entire contents of which are herein incorporated by reference). A clean step is then performed by performing a nitric acid etch to remove any residue within the dicing lanes.

Fig. 1f shows the same workpiece as shown in Fig. 1e, where the mask 35 and the release layer 30 have been removed. The release layer 30 and the mask 35 are removed using an aqueous solution. The dies 55 remaining on the carrier structure 25 are cleaned using standard processes known in the art. The dies 55 are then removed from the carrier structure 25 by a pick and place system (not shown).

As described above, Figure 1 shows a plasma dicing process in which the silicon carbide substrate 10 is fully etched along the dicing lanes 40 by plasma etching to achieve singulation of the workpiece. However, a DBG process can be employed in which the silicon carbide substrate 10 is partially etched along the dicing lanes 40 by plasma etching, and subsequently the thickness of the silicon carbide substrate reduced to achieve singulation of the workpiece.

Numerous variations are possible. For example, the workpiece shown in Figure 1 could be inverted such that the release layer 30 and the mask 35 are applied to the opposite side of the workpiece (e.g., the side of the workpiece comprising isolation components 20). Also, the mask 35 could first be provided on the release layer 30 to form a mask structure, where the mask structure could then be provided on the workpiece.

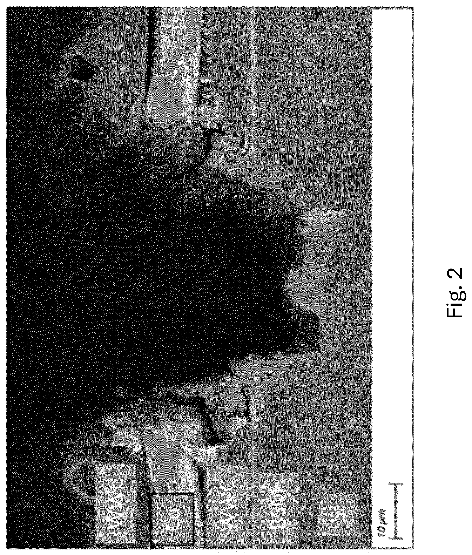

Figure 2 shows an image, generated using a scanning electron microscope, of a silicon substrate having a backside metallisation layer (BSM), a water-washable coating (WWC) of approximately 10µm thickness, a copper mask (Cu) of approximately 8µm thickness and a second water-washable coating (WWC) of approximately 10µm thickness. The silicon substrate has been successfully exposed following an excimer laser scribing step and is ready for plasma etching to form trenches in the substrate. No delamination of the release layer or mask from the backside metallisation layer is observed. Plasma dicing can then be performed using ICP etching with a SF₆ and oxygen based chemistry. A SynapseEtch^{™} ICP module (manufactured by SPTS Technologies Limited) is highly suited for this step, owing to the high density plasma produced. However, other etching apparatus might be used for this purpose.

## Claims

1. A method of plasma dicing a workpiece comprising a compound semiconductor substrate, the method comprising:
providing a workpiece comprising a compound semiconductor substrate;
providing a mask structure on the workpiece, the mask structure comprising an upper layer comprising a hard mask material and a lower release layer between the upper layer and the front side of the workpiece, wherein the mask structure defines one or more dicing lanes; and
plasma dicing the workpiece by a process which comprises plasma etching at least partially through the compound semiconductor substrate along the dicing lanes.

2. A method according to claim 1, wherein the mask structure is provided by:
applying the release layer to the workpiece;
applying the hard mask material to the release layer; and
generating dicing lanes in the release layer and the hard mask material.

3. A method according to claim 1, wherein the mask structure is provided by:
applying the hard mask material to the release layer;
applying the release layer to the workpiece; and
generating dicing lanes in the release layer and the hard mask material.

4. A method according to any preceding claim, wherein the release layer comprises a water-washable coating, polycrystalline silicon, silicon dioxide or germanium oxide, or wherein the release layer comprises an adhesive tape.

5. A method according to any preceding claim, wherein the hard mask material comprises a metal or a metal alloy, optionally wherein the metal or metal alloy comprises one or more of copper, nickel, aluminium, indium and tin.

6. A method according to any preceding claim, wherein the compound semiconductor substrate to hard mask material etch selectivity is at least 10:1.

7. A method according to any preceding claim, wherein the plasma etching of the compound semiconductor substrate comprises fluorine or chlorine based plasma etching, optionally wherein the plasma etching of the compound semiconductor substrate comprises using an etchant gas mixture comprising sulphur hexafluoride and, optionally, oxygen.

8. A method according to any preceding claim, comprising the further step of, after plasma etching the compound semiconductor substrate, removing the release layer and the hard mask material.

9. A method according to any preceding claim, wherein the workpiece comprises the compound semiconductor substrate and one or more additional structures formed on the compound semiconductor substrate and the release layer is in contact with the compound semiconductor substrate, and/or at least some of the additional structures.

10. A method according to any preceding claim, wherein the release layer comprises a plurality of release coatings; and/or wherein the compound semiconductor substrate: is a silicon carbide substrate.

11. A method according to any preceding claim wherein the compound semiconductor substrate is fully etched along the dicing lanes by the plasma etching to achieve singulation of the workpiece.

12. A method according to any one of claims 1 to 10, wherein the compound semiconductor substrate is partially etched along the dicing lanes by the plasma etching, and subsequently the thickness of the compound semiconductor substrate is reduced to achieve singulation of the workpiece.

13. A method according to any previous claim, wherein the workpiece is attached to a carrier structure, such as a tape and frame carrier structure.

14. A system for plasma dicing a workpiece comprising a compound semiconductor substrate, the system comprising:
a mask providing arrangement configured to provide a mask structure on a workpiece comprising a compound semiconductor substrate, the mask structure comprising an upper layer comprising a hard mask material and a lower release layer between the upper layer and the workpiece, wherein the mask structure defines one or more dicing lanes; and
a plasma etching apparatus configured to plasma etch at least partially through the compound semiconductor substrate along the dicing lanes and, optionally, a material removal apparatus configured to reduce the thickness of the compound semiconductor substrate to achieve singulation of the workpiece.

15. A workpiece comprising a compound semiconductor substrate, the workpiece having a mask structure provided thereon, the mask structure comprising an upper layer comprising a hard mask material and a lower release layer between the upper layer and the workpiece, wherein the mask structure defines one or more dicing lanes.
